## Europäisches Patentamt

## European Patent Office

## Office européen des brevets

(11) Veröffentlichungsnummer : **0 156 006**
**B1**

(12) **EUROPÄISCHE PATENTSCHRIFT**

(45) Veröffentlichungstag der Patentschrift :
27.07.88

(51) Int. Cl.⁴ : **G 01 R 31/28**, G 01 R 31/26

(21) Anmeldenummer : **84114711.9**

(22) Anmeldetag : **04.12.84**

(54) **Verfahren zur automatischen Einstellung des Arbeitspunktes bei Signalverlaufsmessungen mit Korpuskularstrahl-Messgeräten.**

(30) Priorität : **27.02.84 DE 3407041**

(43) Veröffentlichungstag der Anmeldung :
**02.10.85 Patentblatt 85/40**

(45) Bekanntmachung des Hinweises auf die Patenterteilung : **27.07.88 Patentblatt 88/30**

(84) Benannte Vertragsstaaten :
**DE FR GB NL**

(56) Entgegenhaltungen :
**DE-A- 3 235 484**
**SOLID-STATE ELECTRONICS, Band 15, 1972, Seiten 987-992, Pergamon Press, GB; P.E. KUDIRKA u.a.: "Potential measurement and stabilization of an isolated target using electron beams"**
**IEEE TRANSACTIONS ON ELECTRON DEVICES, Band ED-26, Nr. 4, April 1979, Seiten 549-559, IEEE, New York, US; E. WOLFGANG u.a.: "Electron-beam testing of VLSI circuits"**

(73) Patentinhaber : **Siemens Aktiengesellschaft Berlin und München**
**Wittelsbacherplatz 2**
**D-8000 München 2 (DE)**

(72) Erfinder : **Feuerbaum, Hans-Peter, Dr. Ing.**
**Arno-Assmann-Strasse 14**
**D-8000 München 83 (DE)**
Erfinder : **Fazekas, Peter, Dipl.-Ing.**
**Stuntzstrasse 21**
**D-8000 München 80 (DE)**

EP 0 156 006 B1

## Beschreibung

Die Erfindung betrifft ein Verfahren zur automatischen Einstellung des Arbeitspunktes bei Signalverlaufsmessungen mit Korpuskularstrahl-Meßgeräten nach dem Oberbegriff des Anspruchs 1.

Der Signalverlaufsmessung mit Elektronenstrahl-Meßgeräten liegt die Messung der Energieverschiebung der Sekundärelektronen mit einem Gegenfeldspektrometer zugrunde. Eine solche Messung von periodischen Signalverläufen mit einem Gegenfeldspektrometer ist beispielsweise in der US-A-4 220 853 beschrieben. Das Gegenfeld des Spektrometers wird, bezogen auf ein bestimmtes Referenzpotential, in Abhängigkeit von der jeweiligen Verteilung der Sekundärelektronen auf einen vorgegebenen Wert eingestellt. Dieser Arbeitspunkt soll möglichst an der steilsten Stelle derjenigen Kurve liegen, die die Verteilung der Sekundärelektronen beschreibt. Eine solche Einstellung des Arbeitspunktes ermöglicht eine hohe Meßgenauigkeit. Die Verteilung der Sekundärelektronen hängt u. a. von dem Material ab, aus dem der Meßpunkt besteht. Üblicherweise wird die Barriere des Gegenfeldspektrometers auf einen Wert zwischen -6 V bis -8 V eingestellt, bezogen auf Erdpotential. Die Einstellung der Barriere des Gegenfeldspektrometers erfolgt in einer bekannten Rückkopplungsschaltung (US-A-4 277 679) durch Änderung der Verstärkung des Sekundärelektronensignals. Bei dem bekannten Verfahren nach der letztgenannten US-Patentschrift wird der Meßpunkt zur Einstellung der Barriere des Gegenfeldspektrometers auf Erdpotential gelegt und wird sodann die Verstärkung des Sekundärelektronensignals über eine Änderung der Spannung eines in der bekannten Rückkopplungsschaltung verwendeten Fotomultipliers eingestellt. Ein Verfahren zur Arbeitspunkteinstellung nach dieser US-A-4 277 679 erfordert einen Umschalter, mit dem zwischen einer Referenzspannung und einer Betriebsspannung hinund hergeschaltet werden kann, je nachdem, ob gerade eine Arbeitspunkteinstellung oder eine Potentialmessung vorgenommen werden soll.

Bei einem aus der US-A-4 220 854 bekannten Verfahren zur Messung des Potentialverlaufs in einem elektronischen Bauelement wird während der kontinuierlichen Abtastung eines Signalverlaufs das Signal einer konstanten Referenzphase mit gemessen. Die Differenz von Meßsignal und Referenzsignal ist dabei frei von Drift, wohingegen sowohl das Meßsignal als auch das Referenzsignal aufgrund von Kontamination am Meßpunkt jeweils für sich Drifterscheinungen aufweisen.

Aus der DE-A-32 35 484 ist ein Verfahren zur Messung von Signalverläufen bekannt, bei dem zur Unterdrückung von Störungen bei der Messung des Signalverlaufs zu mindestens einem Zeitpunkt eine bekannte Referenzspannung an einem Meßpunkt gemessen wird und bei dem sodann ein Sekundärelektronensignal, welches aus einer Messung einer solchen Referenzspannung resultiert, den Arbeitspunkt einer Rückkopplungsschaltung zur Unterdrückung der Störung steuert.

Aus der Publikation « IEEE Transactions on Electron Devices », Band ED-26, Nr. 4, April 1979, Seiten 549 bis 559 ist es bekannt, stroboskopisch eingetastete Primärkorpuskel auf einen Meßpunkt auftreffen zu lassen.

All die genannten bekannten Meßverfahren setzen voraus, daß der Zeitpunkt bekannt ist, zu dem an einem Meßpunkt ein bestimmtes Referenzpotential anliegt. In all den genannten Veröffentlichungen ist kein Hinweis darauf enthalten, wie ein Arbeitspunkt einer Rückkopplungsschaltung bei einem Elektronenstrahl-Meßgerät auch dann eingestellt werden kann, wenn kein einziger Zeitpunkt bekannt ist, zu dem ein bestimmtes Referenzpotential an einem Meßpunkt vorliegt.

Der vorliegenden Erfindung liegt die Aufgabe zugrunde, ein Verfahren der eingangs genannten Art anzugeben, mit dem eine automatische Arbeitspunkteinstellung auch dann möglich ist, wenn kein bestimmter Zeitpunkt bekannt ist, zu dem ein bestimmtes Referenzpotential an einem Meßpunkt vorliegt.

Diese Aufgabe wird erfindungsgemäß durch ein Verfahren nach dem Anspruch 1 gelöst.

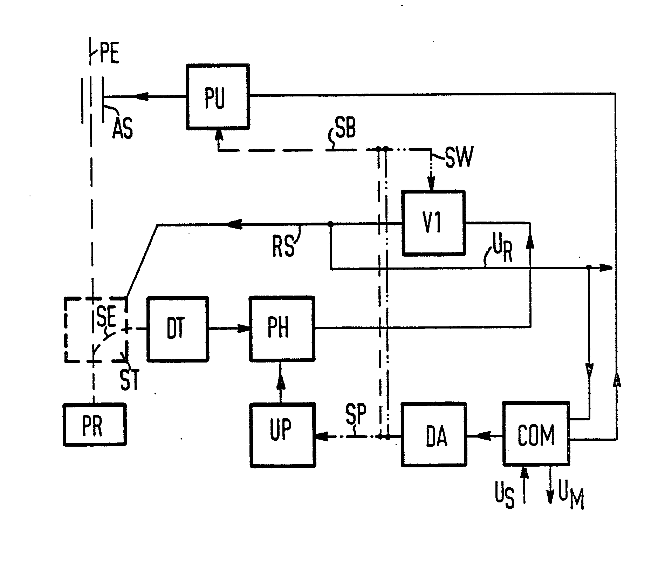

Ausgestaltungen und Vorteile der Erfindung sind in den abhängigen Ansprüchen, der Beschreibung und der Zeichnung dargestellt.

Gemäß der Erfindung wird zunächst bei stroboskopischem Betrieb eines Elektronenstrahl-Meßgerätes ein bestimmter Zeitpunkt ermittelt, zu dem ein Meßpunkt ein bestimmtes Referenzpotential aufweist. Ein Rechner steuert die Eintastphase, zu der die Primärelektronen bezüglich des periodischen Signalverlaufs am Meßpunkt eingetastet werden, und zeichnet qualitativ den dabei ermittelten Signalverlauf in groben Schritten auf. Die Schrittweite zwischen verschiedenen Eintastphasen ist dabei so gewählt, daß kein Signalwechsel « übersehen » werden kann. Um dies zu erreichen, muß die Schrittweite zwischen verschiedenen Eintastphasen an den abgetasteten Zeitbereich des Signalverlaufes angepaßt werden.

Bei logischen Schaltungen weist der periodische Signalverlauf im allgemeinen nur zwei verschiedene Potentiale auf.

Sowohl das Minimum als auch das Maximum eines qualitativ aufgezeichneten Signalverlaufes können zur Ermittlung von solchen Zeitpunkten herangezogen werden, zu denen ein Meßpunkt auf einem bestimmten Referenzpotential liegt. Bei logischen Schaltungen entspricht das Minimum des qualitativ aufgezeichneten Signalverlaufes dabei solchen Phasenpunkten des periodischen Signalverlaufes, bei denen der Meßpunkt auf Erdpotential liegt. Die Eintastphase der Primärelektronen wird mit Hilfe eines Rechners auf einen solchen Phasenpunkt bezüglich des periodischen Signalverlaufes am Meßpunkt eingestellt und während der Arbeitspunkteinstellung konstant gehalten.

Das Maximum eines bei logischen Schaltungen aufgezeichneten Signalverlaufes gibt solche Phasenpunkte an, bei denen der Meßpunkt auf einem solchen Referenzpotential liegt, das der logischen « 1 » entspricht. Wenn als Referenzpotential am Meßpunkt das Erdpotential verwendet wird, so soll die Barriere des Gegenfeldspektrometers zwischen -6 V und -8 V liegen. Wenn als Referenzpotential am Meßpunkt ein anderes Potential verwendet wird, muß der Soll-Wert für die Barriere des Gegenfeldspektrometers entsprechend korrigiert werden.

Bei Meßpunkten, die mehr als zwei mögliche Referenzpotentiale aufweisen, an denen beispielsweise ein beliebiges Wechselstromsignal anliegt, können als mögliche Referenzpotentiale nicht nur Maximum oder Minimum des aufgezeichneten Signalverlaufes, sondern auch Minimum plus ein Bruchteil der Differenz zwischen Maximum und Minimum des Signalverlaufes herangezogen werden.

Die automatische Einstellung des Arbeitspunkts der Rückkopplungsschaltung kann durch Änderung des Verstärkungsfaktors eines dem Detektor nachgeschalteten Verstärkers bewirkt werden. Wenn dem Detektor ein Fotomultiplier nachgeschaltet ist, wird die Verstärkung des Sekundärelektronensignals vorzugsweise über eine Verstellung der Fotomultiplierspannung gesteuert. Die Änderung des Verstärkungsfaktors eines Verstärkers kann über einen Digital-/Analog-Wandler von einem Rechner gesteuert werden. Die Änderung des Verstärkungsfaktors eines Verstärkers oder die Fotomultiplierspannung wird vorzugsweise in einem Intervallhalbierungs-Verfahren so eingestellt, daß die Differenz zwischen dem Meßsignal, das einem bestimmten Referenzpotential entspricht, und dem diesem Referenzpotential ebenfalls entsprechenden Arbeitspunkt zu einem Minimum wird. Beispielsweise kann eine solche Arbeitspunkteinstellung bereits nach zehn Iterationsschritten erfolgt sein. Der tatsächlich in der Rückkopplungsschaltung eingestellte Arbeitspunkt wird gemessen und als Korrekturwert zum Meßsignal während der Signalverlaufsmessung verwendet.

Die Erfindung wird anhand der Zeichnung näher erläutert.

Die Figur zeigt eine Anordnung zur Durchführung eines erfindungsgemäßen Verfahrens.

Primärelektronen PE treffen auf einen Meßpunkt der Probe PR und lösen dort Sekundärelektronen SE aus. Diese Sekundärelektronen SE weisen eine bestimmte Sekundärelektronen-Verteilung auf. Diese Sekundärelektronen-Verteilung erleidet in Abhängigkeit vom Potential am Meßpunkt der Probe PR eine Veschiebung bezüglich der Energie, ohne daß dabei die Form der Sekundärelektronen-Verteilung wesentlich geändert werden würde. Wenn nun das Gegenfeld des Gegenfeldspektrometers ST analog zur Änderung des Potentials am Meßpunkt der Probe PR verändert wird, so kann die Zahl derjenigen Sekundärelektronen SE, die das jeweilige Gegenfeld des Gegenfeldspektrometers ST in Richtung zum Detektor DT hin passieren können, konstant gehalten werden. Die Zahl derjenigen Sekundärelektronen SE, die das Gegenfeldspektrometer ST in Richtung zum Detektor DT hin passieren können, kann bei einem bestimmten Referenzpotential am Meßpunkt der Probe PR durch Einstellung eines bestimmten Gegenfeldes im Gegenfeldspektrometer ST eingestellt werden und sodann mit Hilfe der Rückkopplungsschaltung RS für alle anderen Potentiale am Meßpunkt der Probe PR konstant gehalten werden. Wenn die Sekundärelektronen-Verteilung als Funktion der Energie betrachtet wird, so wird üblicherweise an der steilsten Stelle der Kurve, die diese Sekundärelektronen-Verteilung repräsentiert, ein Punkt definiert, der dem Arbeitspunkt des Gegenfeldspektrometers ST entspricht. Alle Sekundärelektronen SE, deren Energie größer als dieser Punkt an der steilsten Stelle der Sekundärelektronen-Verteilungskurve ist, gelangen zum Detektor DT. Alle Sekundärelektronen SE, deren Energie kleiner ist als diejenige Energie, die dem Punkt an der steilsten Stelle der Sekundärelektronen-Verteilungskurve entspricht, können die Barriere des Gegenfeldspektrometers ST nicht überwinden und gelangen nicht zum Detektor DT. Eine Einstellung des Arbeitspunktes in der gerade beschriebenen Form ermöglicht eine hohe Meßgenauigkeit. Üblicherweise liegt die Barriere des Spektrometers zwischen -6 V und -8 V, sofern als Referenzpotential am Meßpunkt der Probe PR ein Erdpotential angelegt ist.

Die vom Detektor DT nachgewiesenen Sekundärelektronen SE bewirken am Ausgang des an den Detektor DT angeschlossenen Fotomultipliers PH ein Sekundärelektronen-Meßsignal, welches in einem Verstärker V1 verstärkt wird. Am Ausgang des Verstärkers V1 erscheint das Meßsignal $U_R$. Dieses Meßsignal $U_R$ entspricht einerseits derjenigen Spannung, die an die Gegenfeldelektrode des Gegenfeldspektrometers ST angelegt wird. Andererseits gelangt das Meßsignal $U_R$ zu einem Rechner COM und kann dort mit einem vorgegebenen Soll-Wert $U_S$ verglichen werden. Der Rechner COM steuert die Eintastphasen, zu denen der Pulsgenerator PU dem Austastsystem AS für die Primärelektronen PE Eintastsignale übermittelt. Der Rechner COM kann über einen Digital-/Analog-Wandler DA sowohl über eine Leitung SP die Spannung des Fotomultipliers PH als auch über eine Leitung SW den Verstärkungsfaktor eines Verstärkers V1 oder über eine Leitung SB die Pulsbreite der Primärelektronen PE über den Pulsgenerator PU und über das Strahlaustastsystem AS steuern. Die Steuerung der Verstärkung des Fotomultipliers PH erfolgt dabei so, daß die Spannungsversorgung UP des Fotomultipliers PH so angesteuert wird, daß die Spannung des Fotomultipliers PH einen solchen Wert annimmt, daß das für ein Referenzpotential gemessene Sekundärelektronen-Meßsignal $U_R$ mit dem Soll-Wert $U_S$ für dieses Meßsignal übereinstimmt.

Zur Durchführung des erfindungsgemäßen Verfahrens wird an den Meßpunkt der Probe PR ein periodischer Potentialverlauf angelegt. Um innerhalb dieses periodischen Signalverlaufes einen Phasenpunkt herauszufinden, bei dem am Meßpunkt der Probe PR ein Referenzpotential vorliegt, wird die Meßanordnung stroboskopisch
betrieben. Dies bedeutet, daß vom Pulsgenerator
PU über das Austastsystem AS die Primärelektronen PE pulsförmig so eingetastet werden, daß pro
Periode des periodischen Signalverlaufes am
Meßpunkt der Probe PR nur jeweils zu ganz
bestimmten Zeiten des periodischen Signalverlaufes Primärelektronen PE auf den Meßpunkt auftreffen. Der Rechner COM steuert die Eintastphase der Primärelektronen PE und verändert in
Abhängigkeit von der Zeit diese Eintastphase
bezüglich des periodischen Signalverlaufes am
Meßpunkt. Gleichzeitig zeichnet der Rechner
COM qualitativ den Signalverlauf des Meßsignals
$U_R$ in groben Schritten auf.

Die Schrittweite zwischen verschiedenen Eintastphasen ist dabei so gewählt, daß innerhalb
des periodischen Signalverlaufes am Meßpunkt
kein Signalwechsel « übersehen » werden kann.
Zu diesem Zweck wird die Schrittweite zwischen
verschiedenen Eintastphasen an den abgetasteten Zeitbereich des periodischen Signalverlaufes
angepaßt. Bei logischen Schaltungen weist der
periodische Signalverlauf nur Schwankungen
zwischen einem minimalen Wert und einem maximalen Wert auf. Vorzugsweise gibt bei logischen
Schaltungen das Minimum des Signalverlaufes
solche Phasenpunkte des periodischen Signalverlaufes an, bei denen der Meßpunkt auf Erdpotential liegt. Die Eintastphase wird vom Rechner
COM auf einen solchen Phasenpunkt eingestellt
und während der Arbeitspunkteinstellung im stroboskopischen Betrieb konstant gehalten.

Bei der automatischen Einstellung des Arbeitspunktes wird die Verstärkung des Sekundärelektronensignals vorzugsweise über eine Einstellung
der Fotomultiplierspannung geregelt. Diese Einstellung der Fotomultiplierspannung wird vom
Rechner COM vorzugsweise über einen 10 Bit-
Digital-/Analog-Wandler DA gesteuert. Die Fotomultiplierspannung wird vorzugsweise in einem
Intervallhalbierungs-Verfahren so eingestellt, daß
die Differenz zwischen dem einem Referenzpotential am Meßpunkt entsprechenden Meßsignal $U_R$
und dem diesem Referenzpotential am Meßpunkt
entsprechenden Soll-Wert $U_S$ zu einem Minimum
wird. Die Minimierung dieser Differenz zwischen
Meßsignal $U_R$ und Soll-Wert $U_S$ kann beim Inter-
vallhalbierungs-Verfahren beispielsweise in zehn
Iterationsschritten erfolgen. Der tatsächlich eingestellte Arbeitspunkt der Rückkopplungsschaltung RS wird von demjenigen Meßsignal $U_R$
repräsentiert, welches für das ausgewählte Referenzpotential am Meßpunkt gemessen wird. Dieser tatsächlich eingestellte Arbeitspunkt wird
während der teilweisen oder ganzen Messung
einer Periode des Signalverlaufes am Meßpunkt
als Korrektur-Wert verwendet. Schließlich kann
vom Rechner COM auf einem Bildschirm oder auf
einem sonstigen Ausgabe-Gerät ein Meßsignalverlauf $U_M$ ausgegeben werden, der der Differenz
zwischen dem Meßsignal $U_R$ für verschiedene
Potentiale am Meßpunkt und dem Arbeitspunkt entspricht.

Die Messung eines Potentialverlaufes an einem
Meßpunkt wird durch die Erfindung wesentlich
vereinfacht, weil im Gegensatz zum Stand der
Technik vom Elektronenstrahl-Meßgerät selbst
ein solcher Phasenpunkt ermittelt wird, bei dem
ein bestimmtes Referenzpotential an einem Meßpunkt vorliegt. Beim Stand der Technik mußte in
eine Ablaufsteuerung eines Elektronenstrahl-
Meßgerätes eine Information darüber eingegeben
werden, bei welchem Phasenpunkt eines Signalverlaufes ein bestimmtes Referenzpotential an
einem Meßpunkt vorliegt. Alternativ dazu konnte
nach dem Stand der Technik auch über einen
Umschalter unabhängig von einem periodischen
Signalverlauf eine Referenzspannung an einen
Meßpunkt angelegt werden. Dazu waren jedoch
ein zusätzlicher Umschalter und eine zusätzliche
Referenzspannungsquelle erforderlich.

In jedem Fall erleichtert die Erfindung die
Handhabung der quantitativen Messung eines
periodischen Signalverlaufes und vereinfacht die
apparative Anordnung bei einem Elektronenstrahl-Meßgerät erheblich. Überdies läßt sich eine
quantitative Potentialmessung erheblich rascher
durchführen und liefert wegen der digitalen Verarbeitung der Meßergebnisse im Rechner COM
bessere Meßergebnisse, als nach dem Stand der
Technik möglich.

Als Rechner COM kann jeder Tischrechner,
beispielsweise ein Rechner der Fa. BASIS, Typ
108, verwendet werden. Als Digital-/Analog-
Wandler können alle marktüblichen Geräte verwendet werden. Ein Intervallhalbierungs-Verfahren läßt sich in jedem Lehrbuch für numerische
Mathematik finden. Das Herausfinden eines Minimums oder eines Maximums eines Signalverlaufes läßt sich ebenfalls mit sehr einfachen Methoden der numerischen Mathematik ermöglichen.

Ein Verfahren nach der Erfindung liefert auch
deshalb bessere Ergebnisse, als nach dem Stand
der Technik möglich, weil das Meßsignal $U_R$
selbst und nicht irgendein Ausgangssignal eines
Zwischenverstärkers zur Regelung der Fotomultiplierspannung oder des Verstärkungsfaktors des
Verstärkers V1 oder der Pulsbreite der Primärelektronen PE verwendet wird.

Ein erfindungsgemäßes Verfahren ist nicht nur
bei Elektronenstrahl-Meßgeräten anwendbar,
sondern auch — allgemeiner gesprochen — bei
Ionenstrahl-Meßgeräten oder — noch allgemeiner
gesprochen — bei Korpuskularstrahl-Meßgeräten.

Eine Rückkopplungsschaltung zur Durchführung eines erfindungsgemäßen Verfahrens kann
auch so gestaltet sein, daß das Sekundärelektronensignal nach dem Fotomultiplier PH in einem
ersten Verstärker verstärkt wird, daß es sodann in
einem Rechner mit einem Soll-Wert verglichen
wird, daß die Differenz zwischen dem im ersten
Verstärker verstärkten Sekundärelektronensignal
und dem im Rechner vorgegebenen Soll-Wert
einem zweiten Verstärker zugeführt wird und daß
das Ausgangssignal dieses zweiten Verstärkers
sowohl als Meßsignal als auch als Potential für die Gegenfeld-Elektrode des Gegenfeld-Spektrometers ST dient. Bei einer solchen Ausgestaltung der Rückkopplungsschleife RS wird ebenfalls ein Digital-/Analog-Wandler DA vom Rechner mit der Differenz zwischen dem im ersten Verstärker verstärkten Sekundärelektronensignal und dem für dieses Signal vorgegebenen Soll- Wert angesteuert.

Über diesen Digital-/Analog-Wandler kann der Arbeitspunkt sodann genauso eingestellt werden, wie bei dem anhand der Figur beschriebenen Beispiel.

Anstelle von Elektronenstrahl-Geräten sind in entsprechender Weise auch Ionenstrahl-Geräte verwendbar.

In einer alternativen Meßanordnung kann das Ausgangssignal des Fotopultipliers PH einem Analog-/Digital-Wandler zugeführt werden. Das digitale Ausgangssignal dieses Analog-/Digital-Wandlers wird jeweils mit den Inhalten eines Maximalwert-Registers und/oder eines Minimalwert-Registers mittels eines Maximalwert-Komparators bzw. eines Minimalwert-Komparators verglichen und die Inhalte der entsprechenden Register werden gegebenenfalls nach jedem Meßsignal, das einem bestimmten Phasenpunkt des periodischen Signalverlaufs am Meßpunkt der Probe PR entspricht, erneuert. Genauer gesagt ist es so, daß dann, wenn der Wert des Meßsignals größer als der im Maximalwert-Register angegebene Wert ist, der Inhalt des Maximalwert-Registers neu eingeschrieben und dann als Spitzenwert in der positiven Richtung festhalten wird. Hinsichtlich des Minimalwertes gilt, daß jedesmal dann, wenn der Wert des Meßsignals kleiner als der im Minimalwert-Register angegebene Wert ist, der Inhalt des Minimalwert-Registers neu eingeschrieben wird, um den Spitzenwert in negativer Richtung zu erneuern. Am Schluß der Messung werden die im Maximalwert-Register und im Minimalwert-Register enthaltenen Werte miteinander in einer solchen Weise mittels logischer Verknüpfungselemente verknüpft, wie das Referenzpotential als Funktion von Maximalwert und/oder Minimalwert des periodischen Signalverlaufs am Meßpunkt der Probe PR vorgesehen ist. Beispielsweise kann das Referenzpotential nur den Minimalwert oder nur dem Maximalwert oder dem Minimalwert plus einem Bruchteil aus Differenz von Maximalwert und Minimalwert zugeordnet werden.

Wenn das Referenzpotential entweder dem Maximalwert oder dem Minimalwert des periodischen Spannungsverlaufes zugeordnet worden ist, und wenn zugleich mit dem jeweiligen Erneuern der Inhalte von Maximalwert-Register und/ oder Minimalwert-Register auch in irgendeinem Register (Speicherelement) eine Information darüber abgelegt worden ist, welchem Phasenpunkt des periodischen Signalverlaufs der neue Inhalt von Maximalwert-Register bzw. Minimalwert-Register zugeordnet ist, kann zugleich mit der Feststellung von Maximalwert bzw. Minimalwert des periodischen Spannungsverlaufs auch der zugehörige Phasenpunkt des periodischen Spannungsverlaufes angegeben werden. In einem solchen Fall kann die Eintastphase der Primärkorpuskeln sehr einfach auf den betreffenden Phasenpunkt des periodischen Signalverlaufes eingestellt werden und kann sodann der Arbeitspunkt der Rückkopplungsschaltung RS an diesem Phasenpunkt entsprechend der Zeichnung eingestellt werden.

Wenn das Referenzpotential beispielsweise einer Summe von Minimalwert plus einem Bruchteil der Differenz aus Maximalwert und Minimalwert zugeordnet worden ist, so müssen zuerst Minimalwert und Maximalwert des periodischen Spannungsverlaufes ermittelt werden, sodann muß der exakte digitale Wert für die Summe aus dem festgestellten Minimalwert plus dem vorgegebenen Bruchteil der Differenz aus dem festgestellten Maximalwert und dem festgestellten Minimalwert bestimmt werden, sodann muß dieser zuletzt bestimmte Wert, dem das Referenzpotential zugeordnet werden soll, in ein Register (Komparator) eingegeben werden. In einer weiteren Messung müssen ein Meßsignal und der zugehörige Phasenpunkt des periodischen Signalverlaufs beispielsweise mittels Komparatorschaltung ermittelt werden, denen das Referenzpotential zugeordnet ist. Wenn die Eintastphase der Primärkorpuskeln schließlich auf den somit ermittelten Phasenpunkt des periodischen Signalverlaufs eingestellt worden ist, kann der Arbeitspunkt der Rückkopplungsschaltung RS eingestellt werden.

**Patentansprüche**

1. Verfahren zur automatischen Einstellung des Arbeitspunkts bei Signalverlaufsmessungen mit Korpuskularstrahl- Meßgeräten, bei dem stroboskopisch eingetastete Primärkorpuskeln (PE) auf einen Meßpunkt auftreffen und bei dem die Energieverschiebung von an diesem Meßpunkt ausgelösten Sekundärkorpuskeln (SE) mit einem Gegenfeldspektrometer (ST) gemessen wird, und bei dem das Gegenfeld des Gegenfeldspektrometers (ST) über eine Rückkopplungsschaltung (RS) für ein bestimmtes Referenzpotential an einem Meßpunkt auf einen vorbestimmten Soll-Wert ($U_S$) eingestellt wird,
dadurch gekennzeichnet,
— daß an dem Meßpunkt ein periodischer Signalverlauf angelegt wird, der neben anderen Potentialen auch ein bestimmtes Referenzpotential aufweist,
— daß die Eintastphase der eingetasteten Primärkorpuskeln (PE) bezüglich des periodischen Signalverlaufes variiert wird,
— daß auf diese Weise der am Meßpunkt anliegende, periodische Signalverlauf ($U_R$) ganz oder teilweise qualitativ aufgezeichnet wird,
— daß ein Phasenpunkt des qualitativ aufgezeichneten Signalverlaufes ($U_R$) ermittelt wird, der dem bestimmten Referenzpotential am Meßpunkt entspricht,
— daß die Eintastphase der eingetasteten Primärkorpuskeln (PE) auf einen solchen Phasen-

punkt des periodischen Signalverlaufes einge-stellt wird, bei dem das bestimmte Referenzpotential am Meßpunkt anliegt und

— daß während der Arbeitspunkteinstellung diese Eintastphase auf solchen Phasenpunkten gehalten wird, bei denen das Referenzpotential am Meßpunkt anliegt.

2. Verfahren nach Anspruch 1, dadurch gekennzeichnet, daß zur Arbeitspunkteinstellung mit Hilfe eines Rechners (COM) der Verstärkungsfaktor eines Verstärkers (PH, V1) eingestellt wird.

3. Verfahren nach Anspruch 2, dadurch gekennzeichnet, daß die Spannung eines Fotomultipliers (PH), der auch als Vorverstärker dient, eingestellt wird.

4. Verfahren nach einem der Ansprüche 1 bis 3, dadurch gekennzeichnet, daß zur Arbeitspunkteinstellung die Pulsbreite der Primärkorpuskeln (PE) eingestellt wird.

5. Verfahren nach einem der Ansprüche 1 bis 4, dadurch gekennzeichnet, daß die Arbeitspunkteinstellung über einen Digital-/Analog-Wandler (DA) erfolgt.

6. Verfahren nach einem der Ansprüche 1 bis 5, dadurch gekennzeichnet, daß die Arbeitspunkteinstellung mit Hilfe eines Intervallhalbierungs-Verfahrens so durchgeführt wird, daß bezüglich des Referenzpotentials die Differenz zwischen dem Meßsignal ($U_R$) und dem für das Gegenfeld des Gegenfeldspektrometers (ST) vorgegebenen Soll-Wert ($U_S$) minimal wird.

**Claims**

1. A method of automatically setting the operating point in signal curve measurements using corpuscular beam measuring devices, in which stroboscopically keyed-in primary corpuscles (PE) hit a measurement point, and in which the energy shift of secondary corpuscles (SE), triggered at this measurement point, is measured by means of an opposing field spectrometer (ST), and where, via a feedback circuit (RS), the opposing field of the opposing field spectrometer (ST) is set at a predetermined theoretical value ($U_S$) for a specified reference potential at a measurement point, characterised in that

— a periodic signal curve which includes a specified reference potential in addition to other potentials, is connected to the measurement point,

— the keying-in phase of the keyed-in primary corpuscles (PE) in respect of the periodic signal curve is varied,

— that in this way the periodic signal curve ($U_R$), connected to the measurement point, is qualitatively-recorded either in full or in part,

— a phase point of the qualitatively-recorded signal curve ($U_R$) which corresponds to the specified reference potential at the measurement point is determined,

— the keying-in phase of the keyed-primary corpuscles (PE) is set at a phase point of the periodic signal curve at which the specified reference potential is connected to the measurement point, and

— during the setting of the operating point, this keying-in phase is maintained at those phase points at which the reference potential is connected to the measurement point.

2. A method as claimed in claim 1, characterised in that for the setting of the operating point a computer (COM) is used to adjust the amplification factor of an amplifier (PH, V1).

3. A method as claimed in claim 2, characterised in that the voltage of a photo-multiplier (PH) which also serves as preliminary amplifier is adjusted.

4. A method as claimed in one of the claims 1 to 3, characterised in that for the setting of the operating point, the pulse width of the primary corpuscles (PE) is adjusted.

5. A method as claimed in one of the claims 1 to 4, characterised in that the setting of the operating point is carried out using a digital/analogue converter (DA).

6. A method as claimed in one of the claims 1 to 5, characterised in that the operating point is set with the assistance of an interval halving procedure in such manner that, in relation to the reference potential, the difference between the measured signal ($U_R$) and the theoretical value ($U_S$), preset for the opposing field of the opposing field spectrometer (ST), becomes minimal.

**Revendications**

1. Procédé de réglage automatique du point de fonctionnement dans des mesures de l'allure d'un signal avec des appareils de mesure à rayonnement corpusculaire, dans lequel les corpuscules primaires (PE), qui sont pulsées stroboscopiquement, bombardent un point de mesure, et dans lequel la variation d'énergie de corpuscules secondaires (SE) émises par ce point de mesure est mesurée à l'aide d'un spectromètre à champ antagoniste (ST), et dans lequel le champ antagoniste du spectromètre à champ antagoniste (ST) est réglé à une valeur de consigne (US) prédéterminée, par l'intermédiaire d'un circuit de contre-réaction (RS), pour un potentiel de référence déterminé en un point de mesure, caractérisé en ce que

— au point de mesure est appliquée une allure périodique du signal, qui, outre d'autres potentiels, présente un potentiel de référence déterminé ;

— la phase impulsionnelle des corpuscules primaires (PE) pulsées est modifiées en fonction de l'allure périodique du signal ;

— de cette manière, l'allure périodique du signal ($U_R$) qui est présente au point de mesure est enregistrée qualitativement, totalement ou partiellement ;

— un point de phase de l'allure du signal ($U_R$) qui est tracé qualitativement, est déterminé, qui correspond au potentiel de référence déterminé au point de mesure ;

— la phase impulsionnelle des corpuscules primaires (PE) pulsées, est ajustée sur un point de phase de l'allure périodique du signal, auquel le potentiel de référence est présent au point de mesure ; et que

— pendant le réglage du point de fonctionnement, cette phase impulsionnelle est maintenue en des points de phases auxquels le potentiel de référence est présent au point de mesure.

2. Procédé selon la revendication 1, caractérisé en ce que pour le réglage du point de fonctionnement, le gain d'un amplificateur (PH, V1) est réglé à l'aide d'un calculateur (COM).

3. Procédé selon la revendication 2, caractérisé en ce que l'on règle la tension d'un photomultiplicateur (PH) qui sert également de préamplificateur.

4. Procédé selon une des revendications 1 à 3, caractérisé en ce que pour le réglage du point de fonctionnement, on règle la largeur des impulsions des corpuscules primaires (PE).

5. Procédé selon une des revendications 1 à 4, caractérisé en ce que le réglage du point de fonctionnement s'effectue par l'intermédiaire d'un convertisseur numérique-analogique (DA).

6. Procédé selon l'une des revendications 1 à 5, caractérisé en ce que le réglage du point de fonctionnement est réalisé de telle façon à l'aide d'un procédé dit de division par deux de l'intervalle, qu'en fonction du potentiel de référence, la différence entre le signal de mesure ($U_R$) et la valeur de consigne (US) prévue pour le champ antagoniste du spectromètre à champ antagoniste (ST), devient un minimum.